# FASCICULE DE BREVET EUROPEEN

(11) **EP 0 767 600 B1**
(45) Date de publication et mention de la délivrance du brevet: **28.10.1998**
(21) Numéro de dépôt: 96402079.6
(22) Date de dépôt: 30.09.1996
(51) Int. Cl.: H05K 3/34

(54) **Dispositif de traitement de signaux radiofréquence à composant monté en surface**
Anordnung zur Radiofrequenzsignal-Verarbeitung mit einem oberflächenmontierten Bauteil
Device for processing radio frequency signals having a surface mounted component

(30) Priorité: 03.10.1995 FR 9511602
(43) Date de publication de la demande: 09.04.1997
(73) Titulaire: MATRA NORTEL COMMUNICATIONS, 29000 Quimper (FR)
(72) Inventeur: Chapon, Thierry, 78490 Montford L'Amaury (FR)
(74) Mandataire: Loisel, Bertrand

(56) Documents cités:
- EP-A- 0 531 126
- PATENT ABSTRACTS OF JAPAN vol. 18, no. 144 (E-1521), 10 Mars 1994 & JP-A-05 327225 (NEC CORP.), 10 Décembre 1993,
- PATENT ABSTRACTS OF JAPAN vol. 18, no. 230 (E-1542), 26 Avril 1994 & JP-A-06 021628 (NEC CORP.), 28 Janvier 1994,
- PATENT ABSTRACTS OF JAPAN vol. 18, no. 255 (E-1548), 16 Mai 1994 & JP-A-06 037430 (MATSUSHITA ELECTRIC IND CO), 10 Février 1994,
- PATENT ABSTRACTS OF JAPAN vol. 18, no. 255 (E-1548), 16 Mai 1994 & JP-A-06 037431 (MATSUSHITA ELECTRIC IND CO), 10 Février 1994,

## Description

La présente invention concerne un dispositif de type circuit imprimé pour le traitement de signaux radiofréquence.

Il est connu d'utiliser des composants radiofréquence montés en surface (filtres ou mélangeurs par exemple) sur un substrat ayant un plan de masse externe. Les contraintes d'intégration, liées à l'essor actuel des radiocommunications, conduisent à installer des composants montés en surface (CMS) sur les deux faces du substrat, de sorte qu'on est amené utiliser un substrat ayant un plan de masse interne, et des trous de rappel de masse entre les plans de masse interne et externe. Ces trous de rappel de masse doivent être proches des plages de connexion du composant CMS au plan de masse externe pour limiter les inductances parasites risquant d'altérer la réponse du dispositif aux hautes fréquences.

Lors de la fabrication industrielle d'un tel circuit imprimé, les soudures de connexion du composant CMS sont le plus souvent réalisées par refusion au four d'une pâte à souder. Le composant peut ainsi être câblé automatiquement en usine. Néanmoins, il est souvent exigé que le composant puisse également être câblé manuellement à l'aide d'un fer à souder, ou encore à la vague, ceci afin de permettre la réparation d'un dispositif défectueux à la suite d'une avarie ou, plus fréquemment, à l'issue d'un contrôle de qualité en fabrication. Permettre un câblage manuel du composant impose que les plages du plan de masse externe sur lesquelles est connecté le composant CMS soient délimitées par un frein thermique afin de confiner les zones chauffées pendant le soudage. Ces freins thermiques posent à leur tour des problèmes d'inductance parasite entre le composant et la masse.

Un but de la présente invention est de proposer un agencement pour un dispositif de traitement de signaux radiofréquence à composant CMS, qui puisse être câblé manuellement si on le souhaite, tout en présentant une inductance parasite limitée.

L'invention propose ainsi un dispositif de traitement de signaux radiofréquence, comprenant un substrat multicouches et au moins un composant monté en surface dudit substrat, dans lequel le substrat comporte un plan de masse interne et un plan de masse externe compris dans la surface sur laquelle est monté le composant, avec des trous métallisés de rappel de masse reliant les plans de masse interne et externe, le composant ayant au moins une portion soudée sur une plage métallisée respective appartenant au plan de masse externe. Selon l'invention, cette plage métallisée a un périmètre partiellement non métallisé formant frein thermique, et au moins un des trous de rappel de masse est situé à l'intérieur dudit périmètre non métallisé.

Dans cet agencement, les trous de rappel de masse sont très proches du composant CMS, et d'autre part le trajet électrique entre le composant et la masse ne passe pas par les portions rétrécies du frein thermique de sorte que les inductances parasites peuvent être rendues très faibles. L'agencement simple proposé par l'invention répond ainsi de façon combinée à des impératifs de performance du composant CMS (faible inductance parasite) et de mise en oeuvre industrielle (câblage manuel possible grâce aux freins thermiques).

D'autres particularités et avantages de la présente invention apparaîtront dans la description ci-après d'un exemple de réalisation préféré mais non limitatif, en référence aux dessins annexés dans lesquels :
- la figure 1 est un schéma synoptique d'un étage radio pouvant comprendre un ou plusieurs dispositifs selon l'invention ;
- la figure 2 est une vue en perspective d'un composant CMS pouvant faire partie d'un dispositif selon l'invention ;
- la figure 3 est une vue schématique de dessus illustrant le montage du composant CMS sur son substrat ; et
- la figure 4 est une vue schématique de dessus illustrant l'agencement relatif des freins thermiques et des trous de rappel de masse.

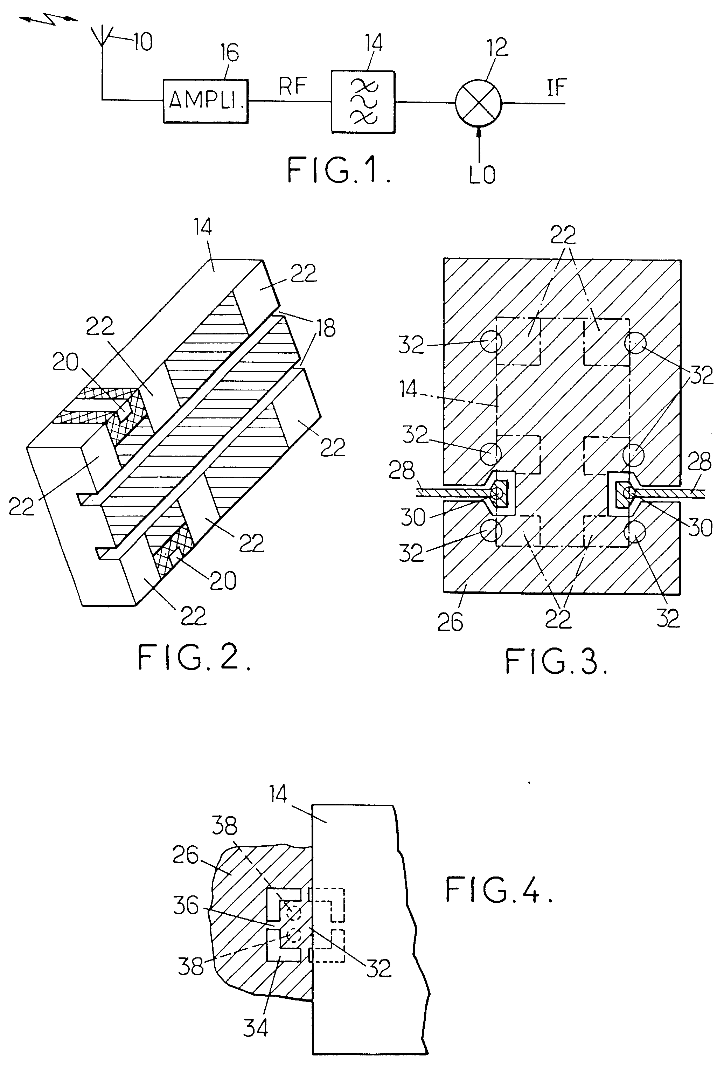

La figure 1 montre les trois principaux composants de l'étage radio d'une station de radiocommunication fixe ou mobile. Dans le sens de l'émission, l'étage radio reçoit un signal de fréquence intermédiaire IF et produit le signal qui attaque l'antenne 10. Dans le sens de la réception, l'étage radio traite le signal capté par l'antenne 10 pour en extraire un signal de fréquence intermédiaire IF. Un ordre de grandeur typique des fréquences radio traitées est le gigahertz dans le cas d'un système de radiotéléphonie. Les trois principaux composants fonctionnels de l'étage radio sont un mélangeur 12, un filtre passe-bande 14 et un amplificateur de puissance 16. Chacun de ces trois composants peut être réalisé sous forme d'un composant CMS rapporté sur un substrat de circuit imprimé.

On décrit ci-après l'invention dans le cas particulier du filtre passe-bande 14, mais on comprendra qu'elle peut s'appliquer à d'autres composants de l'étage radio tels que le mélangeur 12 ou l'amplificateur de puissance 16.

Le filtre à montage en surface représenté sur la figure 2 est un résonateur de forme générale rectangulaire avec des dimensions de l'ordre du centimètre. Sa face inférieure, destinée à être appliquée contre le substrat, est munie de deux gorges longitudinales 18. Afin de protéger le cuivre du substrat, cette face inférieure est recouverte d'un vernis de protection, ou vernis épargne (représenté par des hachures sur la figure 2) sauf dans les portions 20, 22 destinées à être soudées sur le substrat. Les portions 20 sont les accès de signal (entrée et sortie) du composant, tandis que les portions 22, au nombre de six dans l'exemple représenté, sont prévues pour le raccordement du composant à la masse.

Le substrat recevant ce filtre CMS est un substrat multicouches, constitué par exemple d'un empilement de couches isolantes, par exemple en époxy (εᵣ ≃4,8) d'épaisseur de l'ordre de 100 à 200 µm par couche, et de plans conducteurs en cuivre. Ces plans conducteurs comprennent un plan de masse interne dont l'épaisseur est par exemple de l'ordre de 17 µm, permettant ainsi le montage de composants sur les deux faces du substrat, et des plans de masse externes situés sur les surfaces extérieures du substrat et ayant par exemple une épaisseur de l'ordre de 35 µm. Des trous métallisés, dits trous de rappel de masse, sont prévus entre les plans de masse interne et externe pour les maintenir au même potentiel. Ces trous métallisés ont par exemple un diamètre de l'ordre de 200 à 250 µm.

Sur la face du substrat recevant le filtre CMS 14, le plan de masse externe 26 est interrompu dans les zones de raccordement des accès d'entrée et de sortie 20 du filtre 14 (figure 3). Des lignes coplanaires 28 sont prévues sur cette face dans les zones où le plan de masse externe 26 est interrompu, pour assurer le raccordement électrique des accès d'entrée et de sortie 20. Ces lignes coplanaires 28 ont typiquement une largeur de l'ordre de 800 µm pour une longueur de l'ordre de 10 mm, et elles sont isolées du plan de masse externe 26 par un intervalle non métallisé de l'ordre de 500 µm. Les dimensions précises des lignes 28 sont calculées de façon connue pour ajuster l'impédance d'entrée et de sortie du composant à une valeur caractéristique qui est typiquement de 50 Ω dans le cas d'un système de radiotéléphonie ou de 75 Ω dans le cas d'un système de télévision. L'utilisation de lignes coplanaires 28 en combinaison avec les plans de masse interne et externe permet de respecter de façon fiable et reproductible le gabarit souhaité pour le filtre dans sa bande passante.

La figure 3 montre en traits mixtes la disposition du filtre CMS 14 sur le substrat. Les cercles 30, 32 symbolisent les plages métallisées, appartenant respectivement aux lignes coplanaires 28 et au plan de masse externe 26, où sont soudées les portions 20, 22 du filtre CMS 14. Le soudage peut être réalisé automatiquement par refusion, ou encore manuellement au fer à souder. En ce qui concerne les plages métallisées 30 correspondant aux accès d'entrée et de sortie 20, la séparation entre les lignes 28 et le plan de masse externe 26 constitue un frein thermique empêchant que la chaleur communiquée par le fer à souder se propage vers d'autres zones du dispositif du fait de la forte conductivité thermique du cuivre.

Etant donné qu'une telle séparation n'existe pas au voisinage des plages 32 de raccordement à la masse, on prévoit d'y disposer des freins thermiques comme illustré sur la figure 4. On voit que la plage métallisée 32 a un périmètre 34 partiellement non métallisé formant le frein thermique. La largeur de ce périmètre non métallisé 34 est par exemple de l'ordre de 1 mm. La liaison électrique entre la plage 32 et le reste du plan de masse externe 26 est assurée, dans l'exemple représenté, par quatre segments métallisés 36 situés entre les secteurs non métallisés du périmètre 34, et qui ont typiquement une largeur de l'ordre de 500 µm pour une longueur de l'ordre de 1 mm. La dimension de la plage 32 délimitée par le périmètre 34 est par exemple de l'ordre de 10 à 20 mm².

La figure 4 montre également des trous de rappel de masse 38 situés dans la plage 32 à l'intérieur du périmètre 34. Grâce à cet agencement, le contact électrique entre les portions 22 du composant CMS 14 et le plan de masse interne du substrat est relativement direct et n'introduit donc qu'une très faible impédance parasite. Les trous de rappel de masse 38 traversent en général toute l'épaisseur du substrat, de sorte que s'il est prudent de les obturer avant de procéder au soudage du composant CMS, afin d'éviter que la soudure (un eutectique étain-plomb par exemple) déborde sur l'autre face du substrat. On utilise pour cela, comme il est usuel dans la technologie des circuits imprimés, un vernis spécial d'obturation ('tenting") appliqué par sérigraphie, pouvant être le même que celui servant à l'obturation des trous de via que comporte par ailleurs le substrat.

## Revendications

1. Dispositif de traitement de signaux radiofréquence, comprenant un substrat multicouche et au moins un composant (14) monté en surface dudit substrat, dans lequel le substrat comporte un plan de masse interne et un plan de masse externe (26) compris dans la surface sur laquelle est monté le composant, avec des trous métallisés de rappel de masse (38) reliant les plans de masse interne et externe, le composant (14) ayant au moins une portion (22) soudée sur une plage métallisée respective (32) appartenant au plan de masse externe (26), caractérisé en ce que ladite plage métallisée (32) a un périmètre partiellement non métallisé (34) formant frein thermique, et en ce qu'au moins un des trous de rappel de masse (38) est situé à l'intérieur dudit périmètre non métallisé (34).

2. Dispositif selon la revendication 1, caractérisé en ce que la surface du substrat sur laquelle est monté le composant (14) présente des lignes métallisées coplanaires (28) isolées du plan de masse externe (26), pour le raccordement d'accès de signal (20) du composant.

## Patentansprüche

1. Vorrichtung zur Verarbeitung von Hochfrequenzsignalen mit einem Mehrschichtsubstrat und mindestens einem auf diesem Substrat oberflächenmontierten Bauteil (14), bei der das Substrat eine innere Masseebene und eine in der Oberfläche, auf welcher das Bauteil montiert ist, enthaltene äußere Masseebene (26) mit metallisierten Masseverbindungslöchern (38) zum Verbinden der inneren und äußeren Masseebene aufweist, wobei das Bauteil (14) mindestens einen Abschnitt (22) aufweist, welcher auf eine jeweilige, zur äußeren Masseebene (26) gehörige metallisierte Anschlußfläche (32) gelötet ist, dadurch gekennzeichnet, daß die metallisierte Anschlußfläche (32) einen zum Teil nicht metallisierten Umfangsbereich (34) aufweist, der eine Wärmehemmeinrichtung darstellt, und daß mindestens eines der Masseverbindungslöcher (38) innerhalb des nicht metallisierten Umfangsbereichs (34) gelegen ist.

2. Vorrichtung nach Anspruch 1, dadurch gekennzeichnet, daß die Oberfläche, auf welcher das Bauteil (14) montiert ist, koplanare, von der äußeren Masseebene (26) isolierte metallisierte Leitungen (28) für den Signalanschluß (20) des Bauteils aufweist.

## Claims

1. Radiofrequency signal processing device, comprising a multilayer substrate and at least one component (14) mounted on a surface of said substrate, wherein the substrate has an internal ground plane and an external ground plain (26) formed on the surface where the component is mounted, with metallised ground return holes (38) connecting together the internal and external ground planes, the component (14) having at least one portion (22) welded on a respective metallised area (32) belonging to the external ground plane (26), characterized in that said metallised area (32) has a partly non-metallised perimeter (34) forming a thermal brake, and in that at least one of the ground return holes (38) is located within said non-metallised perimeter (34).

2. Device according to claim 1, characterized in that the surface of the substrate where the component (14) is mounted has coplanar metallised lines (28) insulated from to the external ground plane (26), for the connection of signal ports (20) of the component.
